# EUROPEAN PATENT APPLICATION

(11) **EP 2 757 584 A2**
(43) Date of publication of application: **23.07.2014**
(21) Application number: 14152200.3
(22) Date of filing: 22.01.2014
(51) Int. Cl.: H01L 23/427, H01L 23/473

(54) **Integrated thin film evaporation thermal spreader and planar heat pipe heat sink**

(30) Priority: 22.01.2013 US 201313746453
(71) Applicant: Palo Alto Research Center Incorporated, Palo Alto, California 94304 (US)
(72) Inventor: Paschkewitz, John, San Carlos, CA California 94070 (US)
(74) Representative: Lord, Michael

(57) **Abstract**

A heat dissipation device and method provides thermal spreading and cooling for a heat-producing body. A thin film evaporator in thermal communication with the heat-producing body removes heat from the heat-producing body using a working fluid. A heat pipe integrated with the thin film evaporator, and extending from the thin film evaporator, dissipates heat removed by the thin film evaporator to the external environment of the heat dissipation device. A pumping element at least one of: 1) pumps working fluid to the thin film evaporator; and 2) augments transfer of working fluid to the thin film evaporator.

## Description

### BACKGROUND

The present application relates generally to thermal management. It finds particular application in conjunction with cooling heat-producing bodies, such as integrated circuits, and will be described with particular reference thereto. However, it is to be appreciated that the present application is also amenable to other like applications.

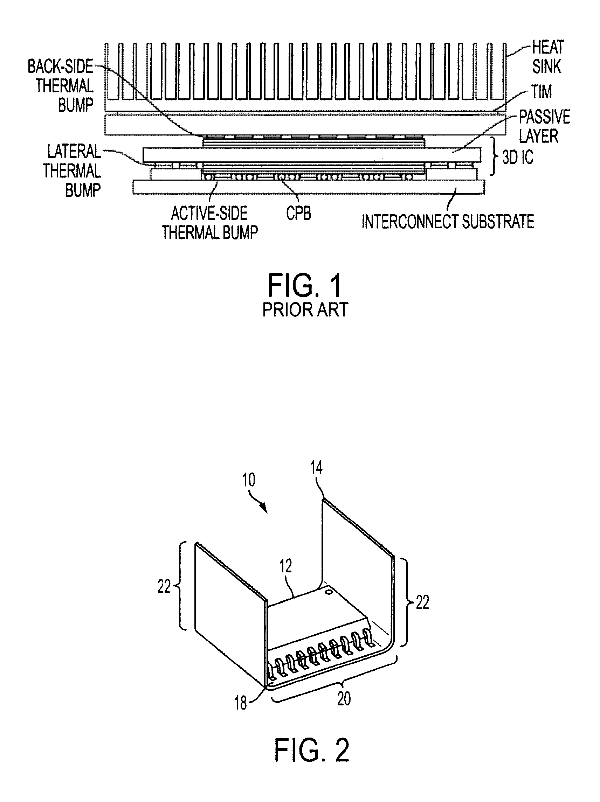

Thermal management for electronics packaging is an active area of research given the increasing demands for high power density and three-dimensional (3D) integrated circuit (IC) architectures. With reference to FIGURE 1, a typical electronics package for a 3D IC is shown. As can be seen, the electronics package relies upon a passive heat sink for thermal management.

Most approaches for electronics gaseous working fluid thermal management are focused on back-side thermal management. An example of such an approach is described in U.S. Patent Application Publication No. 2005/0280162 to Mok et al. which describes an integrated vapor chamber thermal interposer on the backside of an IC. However, increasingly, 3D architectures (e.g., with heat fluxes approaching 100 watts per square centimeter (W/cm2)) have made this approach insufficient.

3D die stacks have severe problems with hotspots on each of the layers. Spreading this heat is a major challenge since the typical combination of solder balls, (relatively) low thermal conductivity filler and copper-filled through silicon vias (TSVs) does not provide a sufficiently conductive thermal path. Further, spreading the heat only partially solves the problem as the heat still needs to be dissipated to the environment.

One proposed solution is described in U.S. Patent Application Publication No. 2010/0044856 to SRI-JAYANTHA et al. SRI-JAYANTHA et al. modifies the active side or lateral thermal path to improve heat transfer away from the 3D IC using an integrated thermal interposer that utilizes either an additional spreader layer on the backside or a very complex micro channel cooler. This former realization demonstrates fairly modest thermal improvement, while the latter entails considerable complexity in terms of fluidic sealing and pumping.

Another proposed solution is to use thermoelectric thermal bump, examples of which are shown in FIGURE 1. However, thermoelectric thermal bumps suffer from the typical shortcomings of thermoelectric materials: poor efficiency and high cost.

Yet another proposed solution is thin film evaporation. It uses a phase change process such as boiling, but mitigates some of the well-known shortcomings of boiling. Specifically, thin film evaporation mitigates the amount of superheat required to initiate boiling, the unpredictability of boiling nucleation sites, handling of combined vapor-liquid flow after boiling (in a flow system) and the critical heat flux (CHF) in which the hot surface dries out if the heat flux is too high.

The foregoing is described in Ohadi et al., "Ultra - Thin Film Evaporation (UTF) - Application to Emerging Technologies in Cooling of Microelectronics", Microscale Heat Transfer Fundametals and Applications, pages 321-338 (2005):
Ultra Thin Film (UTF) evaporation is perhaps one of the most effective methods of heat removal from a high heat flux surface for several reasons:
   1. a small quantity of fluid is required to remove the heat by evaporation at the surface of the thin layer of fluid,
   2. a very high heat transfer coefficient results from the minimized thermal resistance across the thin liquid layer,
   3. the surface experiences a very small temperature rise above the saturation temperature of the working fluid, as long as a sufficient quantity of fluid is provided to wet the surface,
   4. a minimum amount of energy is required to circulate the working fluid due to no pressure drop across the thin film evaporator,
   5. unlike nucleation boiling where a complex set of parameters determine the stability of the system, UTF is virtually conduction across a very thin film,
   6. the upper limit on cooling performance would be limited by the homogeneous nucleation temperature and/or kinetics of vapor formation at a free interface, rather than the relatively low CHF.

The second reason can be clarified using the relationship between heat transferred, thermal resistance and temperature drop, and the definition of the heat transfer coefficient. The heat transfer coefficient R can be defined by Q*R = DT, where Q is heat transferred in watts (W), R is in degrees Celsius per watt (C/W) and DT is temperature drop in degrees Celsius (C). A high thermal resistance means less heat is transferred and there is a large temperature gradient across the material of interest. The thermal resistance and heat transfer coefficient R are related by the relationship R = L/(kA) for conduction, where L is the conduction path length, A is the heat transfer area, and k is the thermal conductivity.

Additional heat dissipation due to evaporation is what makes thin film evaporation particularly compelling. The amount of heat Q that can be removed at the vapor-liquid interface is Q = m(ΔHᵥ), where m is the mass flow of evaporating liquid and (ΔHᵥ) is the latent heat of vaporization of the refrigerant. Taking a 2 centimeter (cm) X 2 cm die, as typical of integrated circuit packages, and a thermal density of 25 W/cm2, the heat to transfer is 100 W. Using water as a heat transfer fluid, the latent heat is 2260 joules per gram (J/g), so the amount of mass flux is 25/2260 = 0.01 grams per second (g/s) or 10 microliters per second (µL/s) of fluid must be evaporated to dissipate this much heat.

In view of this, it is clear that large heat transfer area A and small conduction path length L provide a small conduction resistance through the thin film, which increases the amount of heat transferred to the phase change interface. A challenge in thin film evaporator design is feeding the thin film with enough material to match the evaporation rate for high heat fluxes. One solution is to employ electrohydrodynamics (EHD) polarization pumping to draw a thin film of dielectric liquid along a hot surface. However, this solution suffers from orientation dependence and the resulting film is not especially thin. Even so, this solution has been shown to be able to transfer heat fluxes of up to 40 W/cm2.

It is well-known in the heat pipe community that a significant fraction of heat transfer in the evaporator section of heat pipes occurs in the thin film region where conductive losses are low and evaporation rates are highest. As such, there has been significant work on using wicking structures to maximize the thin film region. A realization of such work combines the application of an actively pumped microchannel cooler with a porous membrane for evaporation. The evaporation rate is augmented with air jet impingement to further improve the heat transfer. This realization demonstrates the ability to dissipate a heat flux of 500 W/cm2. However, this realization requires external infrastructure for pumping and a relatively large thin film. Roughly 85% of the heat transfer is due to the forced convection in the microchannel.

The present application provides new and improved methods and systems which overcome the above-referenced challenges.

### BRIEF DESCRIPTION

In accordance with one aspect of the present application, a heat dissipation device to provide thermal spreading and cooling for a heat-producing body is provided. A thin film evaporator in thermal communication with the heat-producing body removes heat from the heat-producing body using a working fluid. A heat pipe integrated with the thin film evaporator, and extending from the thin film evaporator, dissipates heat removed by the thin film evaporator to the external environment of the heat dissipation device. A pumping element at least one of: 1) pumps working fluid to the thin film evaporator; and 2) augments transfer of working fluid to the thin film evaporator.

In accordance with another aspect of the present application, a heat dissipation method to provide thermal spreading and cooling for a heat-producing body is provided. By a thin film evaporator in thermal communication with the heat-producing body, heat from the heat-producing body is removed using a working fluid. By a heat pipe integrated with the thin film evaporator and extending from the thin film evaporator, heat removed by the thin film evaporator is dissipated to the external environment of the heat dissipation device. By a pumping element, at least one of: 1) working fluid is pumped to the thin film evaporator; and 2) transfer of working fluid to the thin film evaporator is augmented.

In accordance with another aspect of the present application, a heat dissipation device to provide thermal spreading and cooling for a heat-producing body is provided. A sealed housing includes a fluid reservoir of working fluid in liquid phase and a vapor chamber, the heat-producing body thermally coupled to an external surface of the sealed housing. A thin film evaporator is within the sealed housing and in thermal communication with an internal surface of the sealed housing adjacent the external surface. The thin film evaporator receives working fluid in liquid phase from the fluid reservoir and vaporizes the received working fluid to working fluid in gaseous phase using heat from the heat-producing device. A heat pipe within the sealed housing transfers the working fluid in gaseous phase away from the thin film evaporator, condenses the working fluid in gaseous phase to liquid phase, and returning the condensed working fluid to the fluid reservoir. A pumping element at least one of: 1) pumps working fluid to the thin film evaporator; and 2) augments transfer of working fluid to the thin film evaporator.

### BRIEF DESCRIPTION OF THE DRAWINGS

FIGURE 1 illustrates an electronics package relying on passive cooling;
FIGURE 2 illustrates an embodiment of a heat dissipation device according to aspects of the present application;
FIGURE 3A illustrates a cross sectional view of the heat dissipation device of FIGURE 2;
FIGURE 3B illustrates an alternative cross sectional view of the heat dissipation device of FIGURE 2;
FIGURE 4 illustrates a return wick according to aspects of the present application; and
FIGURE 5 illustrates another embodiment of a heat dissipation device according to aspects of the present application.
FIGURE 6 illustrates another embodiment of a heat dissipation device using pulsating heat pipe technology according to aspects of the present application.
FIGURE 7 illustrates another view of the heat dissipation device according to FIGURE 6.

### DETAILED DESCRIPTION

This present application combines an actively driven thin film evaporator for spreading heat with an integrated planar heat pipe extended surface for heat sinking. The thin film evaporator allows for a high rate of heat removal to remove hot spots, and the integrated planar heat pipe transports heat from the thin film evaporator to an extended surface for dissipation to the environment or sinking to an interposer layer.

With reference to FIGURE 2, a perspective view of a heat dissipation device **10** of the present application is provided. The heat dissipation device **10** provides thermal spreading and cooling to an associated heat-producing body **12,** such as an integrated circuit (IC) package (illustrated). Typically, but not necessarily, the IC package is three-dimensional (3D). As will be seen, the heat dissipation device **10** is capable of managing heat fluxes of 10 to 1000 Watts per square centimeter (W/cm2) or more, such as 100 W/cm2.

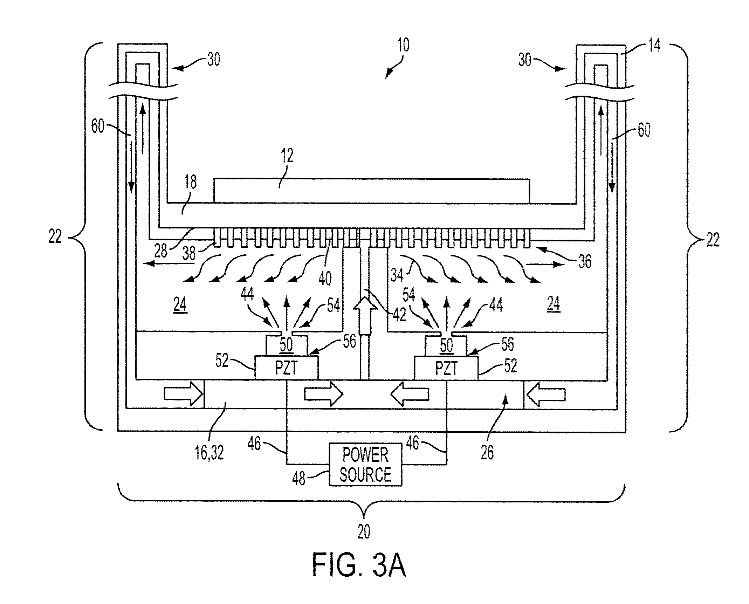

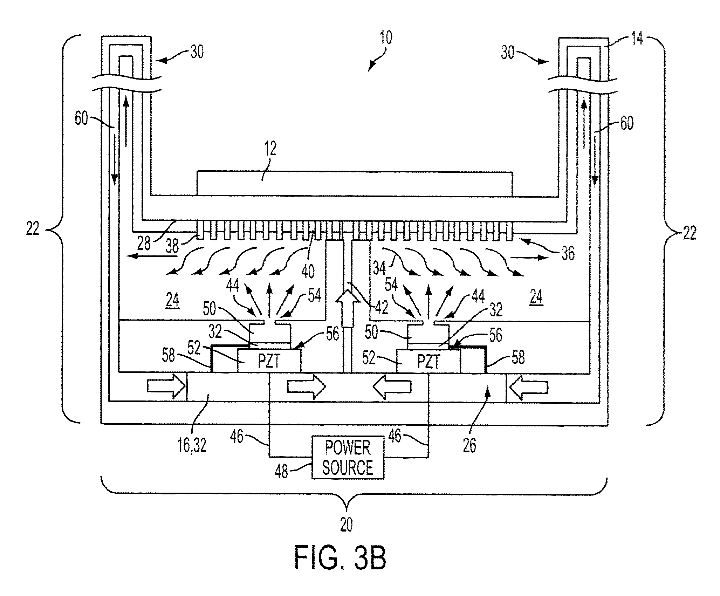

The heat dissipation device **10** includes a sealed housing **14,** which is constructed of a thermally conductive material. The thermally conductive material can, for example, include one or more of copper, copper foil, copper alloys, aluminum, aluminum alloys, polyimides, metals, and the like. The sealed housing **14** can be flexible and seals in a working fluid **16** (FIGURES 3A & B) for transfer of heat away from the heat-producing device **12,** as discussed hereafter. Advantageously, when the sealed housing **14** is flexible, the sealed housing **14** can be shaped after manufacture when installing the heat dissipation device **10** for the heat-producing body **12.**

An external surface **18** of an interface portion **20** of the sealed housing **14** thermally contacts the heat-producing body **12.** For example, the external surface **18** can directly contact the heat-producing body **12.** As another example, the external surface **18** can indirectly contact the heat-producing body **12** by way of a substrate upon which the heat-producing body **12** rests or a thermal interface material intermediate the heat-producing body **12** and the external surface **18.** Typically, the interface portion **20** is formed from copper, copper foil, copper alloys, aluminum, or aluminum alloys, but other materials are contemplated.

Extending away from the interface portion **20,** the sealed housing **14** further includes one or more extended portions or fins **22** (two as illustrated). As discussed hereafter, the extended portions **22** are used to convey heat into the external environment, typically by convection, or to sink heat to an interposer layer. The extended portions **22** are typically formed from a flexible polyimide or metallic substrate to allow the extended portions **22** to be shaped into a desired form factor after manufacture, but other materials are contemplated.

With reference to FIGURES 3A & 3B, within the sealed housing **14,** the heat dissipation device **10** includes a vapor chamber **24** and a fluid reservoir **26.** The vapor chamber **24** includes an internal surface **28** of the interface portion **20** adjacent the external portion **18** of the interface portion **20.** Further, the vapor chamber **24** extends into each of the extended portions **22** of the sealed housing **14,** typically to the distal ends **30** of the extended portions **22.** The fluid reservoir **26** is typically disposed in the interface portion **20** of the sealed housing **14** central to the extended portions **22.**

The fluid reservoir **26** holds working fluid **16** in the liquid phase (i.e., liquid working fluid **32**), and the vapor chamber **24** holds working fluid **16** in the gaseous phase (i.e., gaseous working fluid **34** shown by the arrows in the vapor chamber **24**)**.** The working fluid **16** can include, for example, water, Freon, acetone, alcohol, and the like. As described hereafter, the working fluid **16** is employed to transfer heat away from the heat-producing body **12** through the sealed housing **14** using thin film evaporation, where the extended portions **22** act as heat pipes. In this way, heat fluxes of 10 to 1000 Watts per square centimeter (W/cm2) or more can be managed.

The heat dissipation device **10** includes a thin film evaporator **36** for evaporating liquid working fluid **32** from the fluid reservoir **26** into gaseous working fluid **34** with heat from the heat-producing body **12.** Typically, the thin film evaporator **36** is actively driven to ensure sufficient transfer of working fluid **16** to cool the heat-producing body **12,** as discussed above, but it can also be passive. For example, the thin film evaporator **36** can be actively driven when the heat-producing body **12** is producing heat exceeding a predetermined threshold and passively driven when the heat-producing body **12** is producing heat less than the predetermined threshold.

The thin film evaporator **36** includes an evaporator wick **38** in thermal contact with the internal surface **28** of the interface portion **20** of the sealed housing **14** and within the vapor chamber **24.** Typically, the surface area of the evaporator wick **38** in contact with the internal surface **28** is approximately (i.e., +/- 5%) equal to, or greater than, the surface area of the heat-producing device **12** in contact with the external surface **18.** The evaporator wick **38** receives liquid working fluid **32** from the fluid reservoir **26** and disperses the liquid working fluid **32** substantially uniformly on the internal surface **28** of the interface portion **20** of the sealed housing **14** to form a thin layer **40** of liquid working fluid **32.** Suitably, the evaporator wick **38** is engineered to maximize the extent of capillary wicking and the area of the thin layer **40.**

The heat dissipating device **10,** particularly the thermal coupling with the heat-producing body **12,** is designed to allow sufficient transfer of heat to the thin layer **40** of liquid working fluid **32** to cool the heat-producing body **12.** The heat transferred from the heat-producing body **12** to the thin layer **40** of liquid working fluid **32** is dictated by the heat transfer coefficient R for conduction, where R = L/(kA), L is the conduction path length, A is the heat transfer area, and k is the thermal conductivity. The greater the heat transfer coefficient R, the less transfer of heat. Hence, the greater the area of the thin layer **40** of liquid working fluid **32** and the thermal conductivity of the material intermediate the heat-producing body **12** and the thin layer **40** of liquid working fluid **32,** the greater the heat transfer. Similarly, the less the conduction path length, the greater the heat transfer.

A feed conduit **42** of the sealed housing **14** extends between the fluid reservoir **26** and the evaporator wick **38** to provide liquid working fluid **32** to the evaporator wick **38** from the fluid reservoir **26.** The evaporator wick **38** draws liquid working fluid **32** from the fluid reservoir **26** by way of the feed conduit **42** using capillary action. This capillary action also serves to disperse the liquid working fluid **32** on the internal surface **28** of the interface portion **20** of the sealed housing **14.** The greater the dispersion of liquid working fluid **32,** the greater the transfer of heat from the heat-producing body **12.** Additional feed channels are also contemplated to improve the transfer of liquid working fluid **32** to the evaporator wick **38.**

One or more synthetic jets **44** (two as illustrated) within the sealed housing **14** can be employed to improve the transfer of liquid working fluid **32** to gaseous working fluid **34** by removing gaseous working fluid **34** from the vapor chamber **24** and cooling the evaporator wick **38** to allow greater dispersion of the liquid working fluid **32** before evaporation. Typically, the synthetic jets **44** include a plurality of synthetic jets arranged in a grid or other two-dimensional arrangement to cool, and/or remove gaseous working fluid **34** from, the whole of the evaporator wick **38.** Power is provided to the synthetic jets **44** by way of corresponding wires **46** and power sources **48.**

The synthetic jets **44** create a series of vortex rings of gaseous working fluid **34** in the vapor chamber **24** using corresponding orifices **50** and corresponding oscillating actuators **52.** The axes of the vortex rings are suitably perpendicular to the internal surface **28.** Suitably, the oscillating actuators **52** are piezoelectric actuators (illustrated), but other oscillating actuators are contemplated. While any configuration of the synthetic jets **44** is contemplated, the oscillating actuators **52** of the synthetic jets **44** typically oscillate corresponding diaphragms along the axes of the vortex rings. The oscillating actuators **52** can be the diaphragms (e.g., piezoelectric diaphragms), as illustrated, or merely oscillate the corresponding diaphragms.

The orifices **50** typically include corresponding open ends **54** through which the vortex rings enter the vapor chamber **24** from the orifices **50.** The oscillating actuators **52** can be, for example, positioned within the orifices **50** to push vapor within the orifices **50** out the open ends **54.** The orifices **50** can further include additional corresponding open ends **56** opposite the open ends **54** through which the vortex rings enter the vapor chamber **24** from the orifices **50.** The oscillating actuators **52** can then be, for example, positioned at the additional open ends **54** to create the vortex rings using, for example, diaphragms spanning the additional open ends **54.**

The oscillating actuators **52** can also be employed to pump liquid working fluid **32** to the evaporator wick **38** by way of the feed conduit **42** to ensure that sufficient liquid working fluid **32** is provided to the evaporator wick **38** to prevent dry out of the thin layer **40** of liquid working fluid **32.** Typically, the oscillating actuators **52** are out of plane (i.e., oscillate perpendicular to the direction flow of the liquid working fluid **32).** In such instances, it's important to ensure that the liquid working fluid **32** can only flow in the direction of the feed conduit **42.** Other approaches to pumping the liquid working fluid **32** can also be employed.

One approach to pump liquid working fluid **32** using the oscillating actuators **52** is to employ corresponding diaphragms with the oscillating actuators **52.** As noted above, the oscillating actuators **52** can be the diaphragms (illustrated) or merely oscillate the corresponding diaphragms. In such an approach, the diaphragms partially define the wall of the fluid reservoir **26** and oscillate in and out of the fluid reservoir **26.** Typically, the oscillations are perpendicular to the thin film evaporator **36** and the flow of liquid working fluid **32.** As the diaphragms moves in to the fluid reservoir **26,** the diaphragms pump liquid working fluid **32.** As the diaphragms move out of the fluid reservoir **26,** the diaphragms creates the above described vortex rings.

With specific reference to FIGURE 3B, in addition to, or as an alternative to, using the feed conduit **42** to provide liquid working fluid **32** to the evaporator wick **38,** the synthetic jets **44** can spray liquid working fluid **32** from the fluid reservoir **26,** or some other fluid, on to the evaporator wick **38** substantially uniformly. As illustrated in FIGURE 3B, the synthetic jets **44** receive liquid working fluid **32** from corresponding feed wicks or conduits **58,** which control the flow of liquid working fluid **32** from the fluid reservoir **26** to the orifices **50.** This can help to disperse the liquid working fluid **32** on the internal surface **28** of the interface portion **20** of the sealed housing **14** to form the thin layer **40** of liquid working fluid **32.**

While the thin film evaporator **36** employs the evaporator wick **38** for receiving and dispersing the liquid working fluid **32,** other approaches for receiving and dispersing the liquid working fluid **32** can be employed. For example, a wickless approach or an electrohydrodynamics (EHD) polarization pumping in conjunction with an electrically conductive wick can be employed. As another example, the synthetic jets **44** can spray the liquid working fluid **32,** as described above, on to the internal surface **28** to create the thin layer **40** of liquid working fluid **32** without the evaporator wick **38.** As another example, the thin film evaporator **36** can work without the synthetic jets **44,** but optionally with the oscillating actuators **52** pumping liquid working fluid **32** as described above.

The thin film evaporator **36** and/or the synthetic jets **44** need to be designed to transfer and disperse a sufficient amount of liquid working fluid **32** to remove the heat transferred by the heat-producing body **12** to the thin layer **40** of liquid working fluid **32.** The amount of heat Q that can be removed at the thin layer **40** of liquid working fluid **32** is Q = m(ΔHᵥ), where m is the flow of evaporating liquid work fluid **32** and (ΔHᵥ) is the latent heat of vaporization of the working fluid **16.** Hence, thin film evaporator **36** and the synthetic jets **44** are designed around this equation.

As the thin layer **40** of liquid working fluid **32** evaporates, the gaseous working fluid **34** is transported to the extended portions **22,** typically to the distal ends **30** of the extended portions **22,** by way of the vapor chamber **24.** The synthetic jets **44** facilitate transport of the gaseous working **34** fluid to the extended portions **22** by pushing the gaseous working fluid **34** to the extended portions **22.** Within the extended portions **22,** the gaseous working fluid **34** dissipates and condenses back into liquid working fluid **32.**

Adjacent the vapor chamber **24,** each extended portion **22** includes a return wick **60** at least extending from the corresponding distal ends **30** to the fluid reservoir **26** and typically lining the extended portion **22.** The return wicks **60** capture working fluid **16** as it condenses back to liquid and return it to the fluid reservoir **26,** typically using capillary action. In this way, the extended portions **22** can be viewed as planar heat pipes.

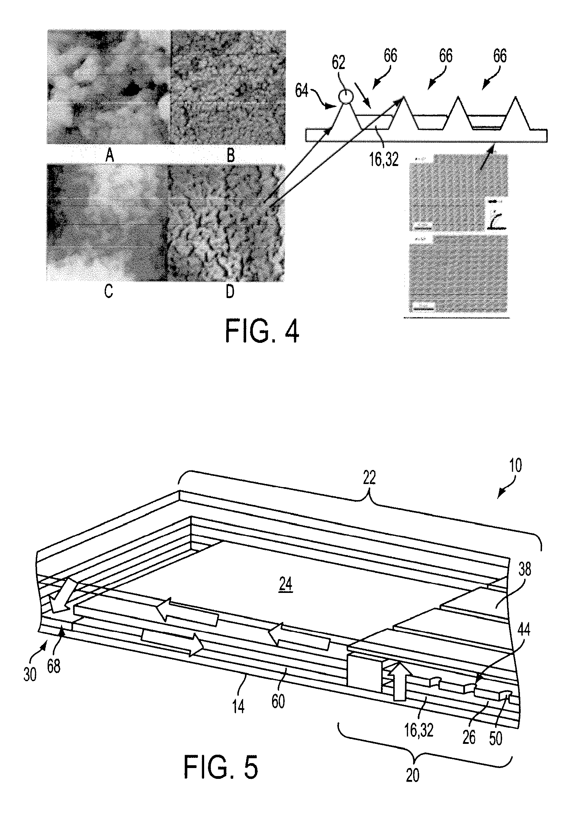

The design of the return wicks **60** is important to the successful operation of the heat dissipation device **10.** The flow of working fluid **16** through the return wicks **60** must be sufficient to complete the working fluid recirculation loop (shown by the arrows). The return wicks **60** are multi-layer wicks with engineered hydrophobic condensation surfaces and a sub-layer of feed channels that return the liquid working fluid **32** to the fluid reservoir **26.** With reference to FIGURE 4, gaseous working fluid **34** condenses into a ball **62** at the apex **64** of one of the feed channels **66** before flowing into the feed channel for transport back to the fluid reservoir **26.** Further, examples of the return wicks **60** at different magnifications (corresponding to images A through D) are provided.

Different approaches to returning the liquid working fluid **32** to the fluid reservoir **26** can also be employed. For example, a wickless approach or an electrohydrodynamics (EHD) polarization pumping in conjunction with an electrically conductive wick can be employed.

The coupling of a heat pipe to a thin film evaporator, as described above, is to be contrasted with conventional thermal packaging arrangement in which the heat sink is connected to a spreader by way of a thermal interface material (See FIGURE 1). Each of these additional layers introduces thermal resistance and increases the potential for hotspots. On the active side, it is even less straightforward to dissipate heat away. The present application rectifies this problem by coupling extended portions or fins into the thermal path. These extended portions can be viewed as planar heat pipes with a conductive wick lining.

With reference to FIGURE 5, another embodiment of the heat dissipation device **10** is illustrated. FIGURE 5 shows a cut away of the heat dissipation device **10** with an emphasis on the extended portions **22.** Also, the extended portions **22** are not bent upward as done in the FIGURES 2, 3A and 3B. As noted above, the heat dissipation device **10** can be shaped as need be after manufacture. The heat dissipation device **10** of this embodiment works as described in connection with the embodiment of FIGURE 2. Hence, elements paralleling those of the discussion of the embodiment of the heat dissipation device **10** of FIGURE 2 are labeled the same.

As illustrated, the evaporator wick **38** receives liquid working fluid **32** using capillary action and/or the synthetic jets **44** from the fluid reservoir **26.** Using this liquid working fluid **32,** the evaporator wick **38** creates the thin layer **40** (not shown in FIGURE 5) of liquid working fluid **32** on the internal surface **28** (not shown in FIGURE 5) of the interface portion **20** of the sealed housing **14.** The gaseous working fluid **34** (not shown in FIGURE 5) generated by evaporation of the liquid working fluid **32** in the thin layer **40** then travels to the extended portions **22** of the sealed housing **14** by way of the vapor chamber **24.** The synthetic jets **44** can be employed to move the gaseous working fluid 34 to the extended portions **22.**

Within the extended portions **22,** the gaseous working fluid **34** cools and condenses back to liquid working fluid **32.** This liquid working fluid **32** can collect at corresponding capture reservoirs **68** at the distal ends **30** of the extended portions **22** and/or be collected by the return wicks **60.** The return wicks **60** return liquid working fluid **32** collected thereby and/or from the capture reservoirs **68** to the fluid reservoir **26,** typically using capillary action. In this way, the working fluid **34** follows a fluid recirculation loop, which is shown by the arrows.

In some embodiments, additional or alternative approaches for removing gaseous working fluid from the interface portion can be employed. For example impinging jets can be employed. Further, in some embodiments, additional or alternative approaches to spreading heat in the extended portions **22** can be employed. For example, although less efficient than the preferred realization, the extended portions **22** can include pulsating heat pipes (PHPs). Such embodiments employing pulsating heat pipes would be limited by the conduction contact area between the PHPs and the vapor chamber.

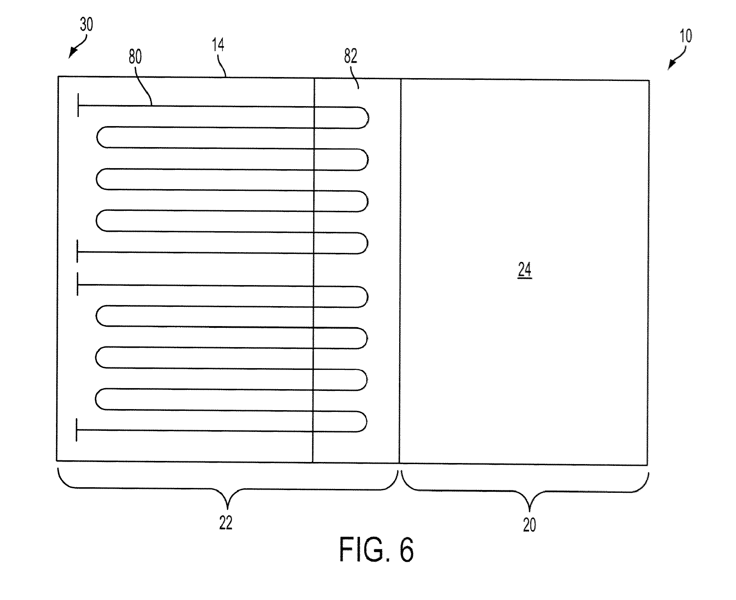

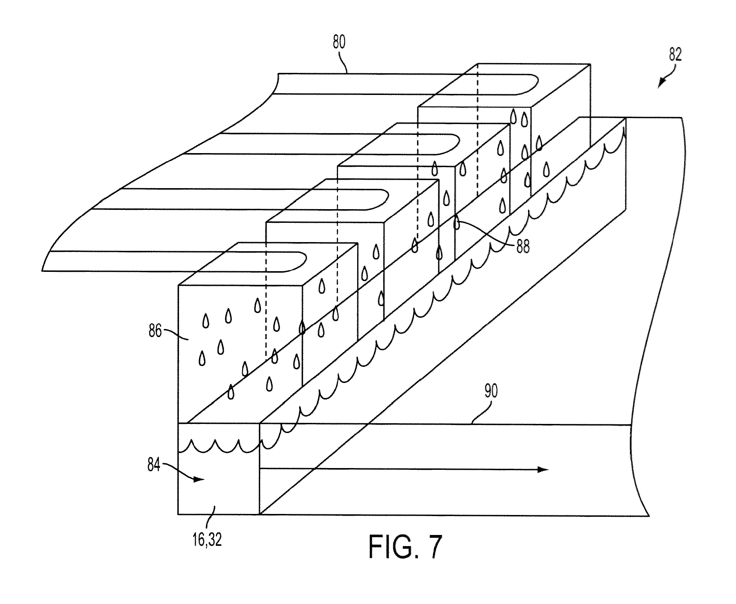

With reference to FIGURES 6 and 7, another embodiment of the heat dissipation device **10** employing PHP technology, which is known in the art, is illustrated. For ease of illustration, only a single extended portion **22** or fin is described and it's is not bent upward as done in the FIGURES 2, 3A and 3B. However, as noted above, the heat dissipation device **10** can be shaped as need be after manufacture. But for the use of PHP technology, the heat dissipation device **10** of this embodiment works as described in connection with the embodiment of FIGURE 2. Hence, elements paralleling those of the discussion of the embodiment of the heat dissipation device **10** of FIGURE 2 are labeled the same.

Referring to FIGURE 6, a top view of the heat dissipation device **10** is illustrated. Of note, all the detail of the interface portion **20** is not shown. Each of the extended portions **22** includes one or more PHPs **80** and a heat exchanger **82.** Alternatively, the extended portions **22** can share a common PHP. The heat exchangers **82** are typically positioned proximate the interface portion **20** at the bases of the corresponding extended portions **22.** Further, the PHPs **80** typically extend from the distal ends **30** of the corresponding extended portions **22** in to the corresponding heat exchangers **82.**

The heat exchangers **82** receive gaseous working fluid **34** from the vapor chamber **24.** Within the heat exchangers **82,** the heat from the gaseous working fluid **34** is absorbed by the PHPs **80,** which transfer the absorbed heat to the distal ends **30** of the extended portions **22** for dissipation to the external environment. As the heat is absorbed by the PHPs **80,** the gaseous working fluid **34** condenses back to liquid working fluid **32** and is returned to the fluid reservoir **26.**

With reference to FIGURE 7, a partial, perspective view of the heat exchangers **82** is illustrated. Each of the heat exchangers **82** includes a capture reservoir **84** in which condensed working fluid **32** collects. The capture reservoirs **84** are typically positioned under the portions of the PHPs **80** extending into the heat exchangers **82.** Further, notwithstanding the orientation of the PHPs **80,** those skilled in the art will appreciate that other orientations are amenable.

"Drop-wise condensation" is generally desired since it gives higher heat fluxes. This is encouraged by coating and/or encapsulating the portions of the PHPs **80** extending into the heat exchangers **82** with hydrophobic material **86.** For example, a thin layer of Polytetrafluoroethylene (PTFE), such as that found on a nonstick cooking pan, can coat these portions of the PHPs **80.** As illustrated, the PHPs **80** are encapsulated in hydrophobic material **86** and cause droplets **88** of liquid working fluid **32** to form and fall into the capture reservoirs **82.**

To return the condensed working fluid **32** to the fluid reservoir **26,** each of the extended portions **22** includes a return wick **90** extending from the corresponding capture reservoir **84** to the fluid reservoir **26.** The return wick **90** uses capillary action as described above to transfer the liquid working fluid **32** in the captured.

It will be understood that features disclosed in association with particular embodiments are intended to be interchangeable with other embodiments unless the context would prevent it.

## Claims

1. A heat dissipation device to provide thermal spreading and cooling for a heat-producing body, said heat dissipation device comprising:
a thin film evaporator in thermal communication with the heat-producing body to remove heat from the heat-producing body using a working fluid;
a heat pipe integrated with the thin film evaporator, and extending from the thin film evaporator, to dissipate heat removed by the thin film evaporator to the external environment of the heat dissipation device; and
a pumping element to at least one of: 1) pump working fluid to the thin film evaporator; and 2) augment transfer of working fluid to the thin film evaporator.

2. The heat dissipation device according to claim 1, wherein the pumping element includes an oscillating actuator at least one of: 1) pumping working fluid to the thin film evaporator; and 2) augmenting transfer of working fluid to the thin film evaporator; and wherein, optionally, the oscillating actuator is a piezoelectric oscillator.

3. The heat dissipation device according to claim 1 or claim 2, wherein the pumping element is integrated in a sealed housing with the thin film evaporator and the heat pipe.

4. The heat dissipation device according to any of the preceding claims, wherein the pumping element includes a synthetic jet augmenting transfer of working fluid to the thin film evaporator.

5. The heat dissipation device according to any of the preceding claims, wherein the heat pipe is at least one of an integrated planar heat pipe or a pulsating heat pipe.

6. The heat dissipation device according to any of the preceding claims, wherein the thin film evaporator receives working fluid in liquid phase from a fluid reservoir and transfers the received working fluid in liquid phase to gaseous phase using heat from the heat-producing body, and wherein the heat pipe cools and condenses the working fluid in gaseous phase to working fluid in liquid phase and returns the condensed working fluid in liquid phase to the fluid reservoir.

7. The heat dissipation device according to claim 6, wherein the heat pipe returns the condensed working fluid in liquid phase to the fluid reservoir using a return wick.

8. The heat dissipation device according to claim 6 or claim 7, wherein the thin film evaporator includes an evaporator wick to create a thin film transferring the received working fluid in liquid phase to the gaseous phase.

9. The heat dissipation device according to any of claims 6 to 8, further including:
a second heat pipe integrated with the thin film evaporator, and extending from the thin film evaporator, to dissipate heat removed by the thin film evaporator to the external environment of the heat dissipation device, wherein the fluid reservoir is central to the heat pipe and the second heat pipe.

10. The heat dissipation device according to any of claims 6 to 9, wherein working fluid in gaseous phase is transferred to the heat pipe using a vapor chamber, the vapor chamber including the thin film evaporator.

11. The heat dissipation device according to any of the preceding claims, wherein the heat dissipating device includes:
a sealed housing including:
a fluid reservoir for working fluid in liquid phase; and
a vapor chamber extending from the thin film evaporator to the heat pipe;
wherein the thin film evaporator receives working fluid in liquid phase from the fluid reservoir and vaporizes the received working fluid in liquid phase to working fluid in gaseous phase, the working fluid in gaseous phase transferred to the heat pipe by way of the vapor chamber.

12. A heat dissipation method to provide thermal spreading and cooling for a heat-producing body, said heat dissipation method comprising:
by a thin film evaporator in thermal communication with the heat-producing body, removing heat from the heat-producing body using a working fluid;
by a heat pipe integrated with the thin film evaporator and extending from the thin film evaporator, dissipating heat removed by the thin film evaporator to the external environment of the heat dissipation device; and
by a pumping element, at least one of: 1) pumping working fluid to the thin film evaporator; and 2) augmenting transfer of working fluid to the thin film evaporator.

13. The heat dissipation method according to claim 12, further including:
by an oscillating actuator of the pumping element, at least one of: 1) pumping working fluid to the thin film evaporator; and 2) augmenting transfer of working fluid to the thin film evaporator.

14. The heat dissipation device according to claim 12 or claim 13, further including:
by the thin film evaporator:
receiving working fluid in liquid phase from a fluid reservoir; and
transferring the received working fluid in liquid phase to gaseous phase using heat from the heat-producing body; and
by the heat pipe:
cooling and condensing the working fluid in gaseous phase to working fluid in liquid phase; and
returning the condensed working fluid in liquid phase to the fluid reservoir.

15. A heat dissipation device to provide thermal spreading and cooling for a heat-producing body according to any of claims 1 to 11, said heat dissipation device comprising:
a sealed housing including a fluid reservoir of working fluid in liquid phase and a vapor chamber, the heat-producing body thermally coupled to an external surface of the sealed housing;
wherein the thin film evaporator is positioned within the sealed housing and in thermal communication with an internal surface of the sealed housing adjacent the external surface, the thin film evaporator receiving working fluid in liquid phase from the fluid reservoir and vaporizing the received working fluid to working fluid in gaseous phase using heat from the heat-producing device; and,
wherein the heat pipe is positioned within the sealed housing for transferring the working fluid in gaseous phase away from the thin film evaporator, condensing the working fluid in gaseous phase to liquid phase, and returning the condensed working fluid to the fluid reservoir.
